# FASCICULE DE BREVET EUROPEEN

(11) **EP 3 118 103 B1**
(45) Date de publication et mention de la délivrance du brevet: **22.04.2020**
(21) Numéro de dépôt: 16179146.2
(22) Date de dépôt: 13.07.2016
(51) Int. Cl.: B64B 1/14, B64B 1/40, H01L 31/052

(54) **BALLON EQUIPE D'UN GENERATEUR SOLAIRE A CONCENTRATION ET UTILISANT UN AGENCEMENT DE CELLULES SOLAIRES OPTIMISE POUR ALIMENTER EN VOL LEDIT BALLON**
BALLON, DER MIT EINEM SOLARGENERATOR MIT HOHER KONZENTRATION AUSGESTATTET IST UND EINE OPTIMIERTE ANORDNUNG VON SOLARZELLEN ZUR STROMVERSORGUNG IM FLUG DIESES BALLONS NUTZT
BALLOON EQUIPPED WITH A CONCENTRATED SOLAR GENERATOR AND EMPLOYING AN OPTIMISED ARRANGEMENT OF SOLAR CELLS TO POWER SAID BALLOON IN FLIGHT

(30) Priorité: 15.07.2015 FR 1501486
(43) Date de publication de la demande: 18.01.2017
(73) Titulaire: Thales, 92400 Courbevoie (FR)
(72) Inventeur: BOULANGER, Bertrand, 06156 CANNES LA BOCCA (FR); PROST, Jean-Pierre, 06156 CANNES LA BOCCA (FR); CHESSEL, Jean-Philippe, 06156 CANNES LA BOCCA (FR); DARGENT, Thierry, 06156 CANNES LA BOCCA (FR)
(74) Mandataire: Tanguy, Yannick

(56) Documents cités:
- EP-A1- 2 597 031
- WO-A2-2014/028201
- FR-A1- 3 015 149

## Description

La présente invention concerne un ballon équipé d'un générateur solaire à concentration et utilisant un agencement de cellules solaires optimisé pour alimenter en vol ledit ballon.

L'invention concerne en particulier un ballon stratosphérique, destiné à évoluer dans la stratosphère et portant, fixée en dessous, une nacelle avec à son bord une ou plusieurs charges utiles.

De manière générale, les ballons présentent un fort potentiel d'application non seulement en raison de leurs faibles coûts par rapport à ceux des satellites mais également en raison des altitudes auxquelles lesdits ballons évoluent et qu'ils peuvent mettre à profit, notamment les altitudes de la stratosphère s'étendant entre 12 et 45 km.

Tandis que la stratosphère est inaccessible aux satellites et traversée trop rapidement par les fusées-sondes, les ballons, ou aérostats selon la terminologie scientifique, peuvent évoluer durablement dans cette couche dite «moyenne » de l'atmosphère, et sont particulièrement prometteurs pour répondre à un certain nombre d'applications, en particulier dans le domaine des télécommunications.

Classiquement les ballons stratosphériques doivent satisfaire deux exigences :
.- d'une part une exigence de sustentation satisfaite par la fourniture d'un volume d'enveloppe du ballon adéquat ;
.- d'autre part une exigence de propulsion pour piloter et faire suivre au ballon une trajectoire souhaitée, ce qui nécessite de disposer d'une source d'énergie suffisante.

De manière générale et classique, pour qu'un ballon stratosphérique dirigé soit autonome à poste sur une durée de plusieurs mois, il est nécessaire qu'il produise son énergie à l'aide de cellules photovoltaïques. Dans des conditions de vent stratosphérique, typiquement celles d'un vent ayant une vitesse supérieure à 10 m/s, et pour une mission permanente et continue, l'énergie électrique produite le jour est stockée à bord pour être utilisée la nuit. La production d'électricité de jour atteint rapidement plusieurs dizaines de kilowatts et requiert une surface importante de cellules photovoltaïques qui impacte de manière significative et défavorable le bilan de masse du ballon.

Afin de réduire le nombre de cellules photovoltaïques nécessaires à la génération d'une quantité d'énergie électrique suffisante pour une mission donnée et ainsi d'alléger le poids de l'ensemble du ballon, la demande de brevet FR 2 982 840 décrit un ballon, équipé d'un générateur solaire à concentration. Le ballon utilise des moyens photovoltaïques présentant une face active destinée à recevoir des rayons solaires et comporte une enveloppe. L'enveloppe comprend au moins une première zone transparente aux rayons solaires, une seconde zone réfléchissante pour lesdits rayons solaires, une troisième zone comprenant lesdits moyens photovoltaïques. Les seconde et troisième zones sont positionnées et coopèrent de manière à renvoyer les rayons solaires en direction de ladite troisième zone. Le document FR 3 015 149, qui est connu de l'état de la technique, montre toutes les caractéristiques du préambule de la revendication indépendante 1.

Un tel ballon équipé d'un générateur solaire à concentration subit une augmentation de la température au moins localement, ce qui induit des risques de dommages vis-à-vis de l'enveloppe et/ou du gaz porteur que l'enveloppe contient, en particulier lorsque le gaz porteur est inflammable.

De plus, l'utilisation d'un générateur solaire à concentration nécessite un contrôle continu du pointage du concentrateur ou des moyens réfléchissant vers le soleil. En cas d'un dépointage solaire, dicté par exemple par des exigences particulières de mission (pointage d'antenne(s) ou de capteurs) ou des conditions météorologiques ou des limites de suivi du soleil lui-même, il convient de pallier à une baisse rapide de la puissance électrique délivrée par le générateur solaire à concentration lorsque l'angle d'incidence du rayonnement solaire varie par rapport au ballon.

En outre, l'élévation de la température des cellules solaires ou photovoltaïques, induite par la concentration du rayonnement solaire, dégrade l'efficacité des cellules solaires, en termes de conversion de l'énergie solaire en énergie électrique.

Un premier problème technique est de réduire la température du système de concentration pour réduire les risques vis-à-vis de l'enveloppe et du gaz porteur contenu dans l'enveloppe.

Un deuxième problème technique est également de pallier à une baisse rapide de la puissance électrique délivrée par le panneau solaire en fonction de l'angle d'incidence du rayonnement solaire en cas de dépointage solaire.

Un troisième problème technique est également de réduire la température des cellules solaires pour les faire fonctionner avec une meilleure efficacité.

A cet effet, l'invention a pour objet un ballon équipé d'un générateur solaire à concentration comprenant une enveloppe contenant un gaz porteur et un générateur solaire à concentration de rayonnement solaire, le générateur solaire comportant :
.- un réflecteur de rayons solaires, disposé à l'intérieur de l'enveloppe en une première zone de l'enveloppe ;
.- une deuxième zone de l'enveloppe, transparente aux rayons solaires, pour laisser passer les rayons solaires vers le réflecteur, et
.- un premier ensemble de cellules photovoltaïques, disposé en une troisième zone de l'enveloppe, ayant une première face active dirigée vers le réflecteur;
le premier ensemble de cellules photovoltaïques et le réflecteur étant configurés de sorte que le réflecteur concentre les rayons solaires sur la première face active du premier ensemble de cellules photovoltaïques, lorsque le réflecteur est mis en position de pointage solaire ;
ledit ballon étant caractérisé en ce que :
.- le générateur solaire comporte en outre un deuxième ensemble de cellules photovoltaïques, disposé en une quatrième zone de l'enveloppe ou en la troisième zone de l'enveloppe, et ayant une deuxième face active dirigée vers l'extérieur de l'enveloppe; ou
.- le générateur solaire comporte un seul premier ensemble dont les cellules solaires sont des cellules solaires bifaciales et le premier ensemble comporte une deuxième face active dirigée vers l'extérieur de l'enveloppe; et
.- le réflecteur, le premier ensemble seul des cellules photovoltaïques bifaciales ou les premier et deuxième ensembles des cellules photovoltaïques sont configurés de sorte à assurer une production coopérative d'énergie électrique entre la première face active et la deuxième face active tant que le dépointage solaire en roulis du réflecteur est inférieur ou égal en valeur absolue à 10 degrés.

Suivant des modes particuliers de réalisation, le ballon équipé d'un générateur solaire à concentration comprend l'une ou plusieurs des caractéristiques suivantes :
.- le réflecteur, le premier ensemble seul de cellules photovoltaïques bifaciales ou les premier et deuxième ensembles de cellules photovoltaïques sont configurés de sorte à maintenir un éclairement de la deuxième face active tant que le dépointage solaire en roulis de la deuxième face active est inférieur ou égal à 80 degrés ;
.- les premier et deuxième ensembles de cellules photovoltaïques sont distincts et disposés respectivement en des troisième et quatrième zones différentes ;
.- les premier et deuxième ensembles de cellules photovoltaïques sont distincts et comportent chacun des cellules photovoltaïques mono-faciales ; et les premier et deuxième ensembles sont disposés sur et à l'extérieur de l'enveloppe en la même zone ; et les premier et deuxième ensembles sont mutuellement superposés, le deuxième ensemble étant disposé le plus à l'extérieur de l'enveloppe et les faces actives des cellules photovoltaïques des premier et deuxième ensembles étant orientés dans des directions opposées ;
.- le premier ensemble et le deuxième ensemble sont découplés mécaniquement de l'enveloppe en termes de déformations de l'enveloppe et/ou thermiquement de l'enveloppe et du gaz porteur que l'enveloppe contient ;
.- le premier ensemble de cellules photovoltaïques est un ensemble de cellules photovoltaïques bifaciales situé au dessus de la troisième zone de l'enveloppe, chaque cellule bifaciale comportant une première face associée à une première polarisation électrique et une deuxième face associée à une deuxième polarisation électrique ;
.- la technologie de fabrication des cellules bifaciales (206) est une technologie comprise dans l'ensemble formé par la technologie silicium PERT (Passivated Emitter Rear Totally Diffused), la technologie silicium à hétérojonction HTJ (Heterojunction), et la technologie silicium IBC (Interdigitated Back Contact) ;
.- la technologie de fabrication et de connexion des cellules bifaciales est une technologie de fabrication de cellules photovoltaïques bifaciales à hétérojonction combinée à la technologie de connexion SmartWire ou SWCT ;
.- les cellules bifaciales sont des cellules photovoltaïques bifaciales à hétérojonction, agencées entre elles de manière à réaliser une ou plusieurs chaîne de cellules solaires reliées électriquement en série et à permettre une interconnexion planaire des cellules entre elles sur la même face sans avoir recours à des interconnexions traversant l'ensemble en épaisseur d'une de ses faces à l'autre ;
.- l'ensemble des cellules photovoltaïques comporte une pluralité d'interrupteurs électroniques de protection ayant chacun au moins une jonction formant diode pour protéger une ou plusieurs cellules photovoltaïques pour protéger la ou les cellules contre une montée en température consécutive à des défauts d'uniformité d'illumination des deuxièmes faces actives par le réflecteur ;
.- l'ensemble des cellules photovoltaïques bifaciales est découplé thermiquement de l'enveloppe et du gaz porteur que l'enveloppe contient par une structure de support et d'écartement de l'ensemble des cellules de l'enveloppe, la structure de support et d'écartement étant fixée sur l'enveloppe en la troisième zone et l'ensemble des cellules solaires bifaciales étant fixé sur la structure de support et d'écartement, et l'espace délimité par l'enveloppe, la structure et l'ensemble des cellules formant un canal de circulation d'air pour refroidir les cellules solaires bifaciales par convection naturelle ou forcée ;
.- le ballon comporte en outre un ou plusieurs ventilateurs pour faire circuler de l'air dans le canal et refroidir l'ensemble des cellules photovoltaïques ;
.- la structure de support et d'écartement est déformable pour absorber les déformations thermomécaniques de l'enveloppe et/ou maintenir un écart suffisant entre l'enveloppe et l'ensemble des cellules pour permettre le refroidissement des cellules ;

Selon l'invention, la deuxième zone de l'enveloppe, transparente aux rayons solaires, entoure partiellement ou complètement la troisième zone (26) d'emplacement du premier ensemble de cellules photovoltaïques destinées à recevoir les rayons solaires du réflecteur, et la surface de la deuxième zone (16) est ajustée pour assurer un éclairement suffisant des cellules photovoltaïques du premier ensemble et pour éviter un échauffement excessif des cellules solaires et/ou de l'enveloppe et/ou du gaz porteur que l'enveloppe contient.

L'invention sera mieux comprise à la lecture de la description de plusieurs formes de réalisation qui va suivre, donnée uniquement à titre d'exemple et faite en se référant aux dessins sur lesquels :
- la Figure 1 est une vue d'un premier mode de réalisation d'un ballon selon l'invention équipé d'un générateur solaire à concentration et de deux ensembles de cellules solaires mono-faciales, le ballon étant placé dans une première configuration de fonctionnement pour laquelle le réflecteur concentrateur présente un angle de dépointage solaire peu élevé inférieur ou égal à 10 degrés ;
- la Figure 2 est une vue du ballon selon l'invention de la Figure 1 placé dans une deuxième configuration de fonctionnement pour laquelle la face active d'un deuxième ensemble de cellules solaires mono-faciales présente un angle de dépointage solaire élevé strictement supérieur à 10 degrés et inférieur ou égal à 80 degrés ;
- la Figure 3 est une vue d'un deuxième mode de réalisation d'un ballon selon l'invention équipé d'un générateur solaire à concentration et d'un unique ensemble à deux faces opposés de cellules solaires bifaciales, le ballon étant placé dans une première configuration de fonctionnement pour laquelle le réflecteur concentrateur présente un angle de dépointage solaire peu élevé inférieur ou égal à 10 degrés ;
- la Figure 4 est une vue du ballon selon l'invention de la Figure 3 placé dans une deuxième configuration de fonctionnement pour laquelle la deuxième face active de l'unique ensemble des cellules solaires bifaciales présente un angle de dépointage solaire élevé strictement supérieur à 10 degrés et inférieur ou égal à 80 degrés ;
- la Figure 5 est une vue schématique d'une cellule solaire ou photovoltaïque bifaciale utilisant une technologie silicium à hétérojonction ;
- la Figure 6 est une vue d'une cellule solaire bifaciale de la Figure 5 utilisant une technologie silicium à hétérojonction combinée à la technologie de connexion SmartWire ou SWCT ;
- la Figure 7 est une vue schématique de l'interconnexion planaire des cellules solaires entre elles, formant une chaine de sources photovoltaïques connectées électriquement en série, de l'ensemble de cellules solaires bifaciales des Figures 3 et 4, limité ici à ladite chaîne ;
- la Figure 8 est une vue d'une coupe partielle de la chaîne des cellules solaires de la Figure 7 dans le sens de l'épaisseur des cellules solaire qui met en évidence l'agencement des cellules et leur schéma d'interconnexion ;
- la Figure 9 est une vue réelle de l'ensemble des cellules solaires de la Figure 7 interconnectées entre elles ;
- la Figure 10 est une vue d'un dispositif de protection pour protéger les cellules solaires de variations brusques d'illumination par les rayons concentrés.

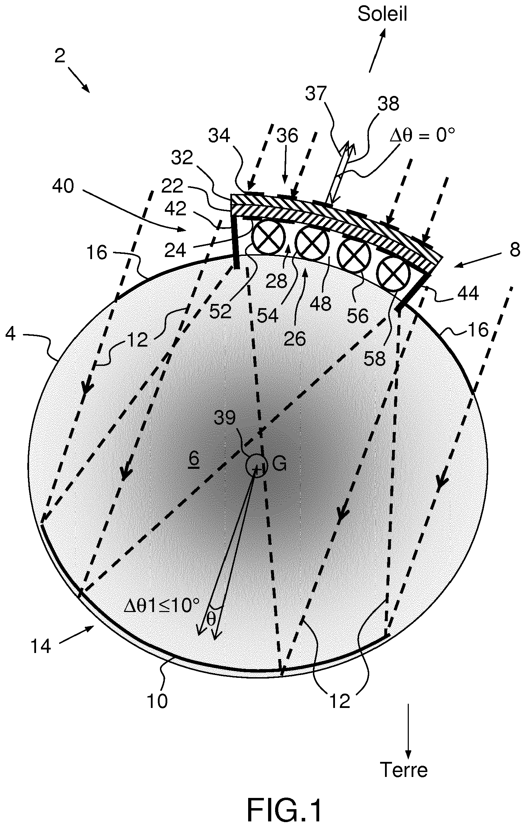

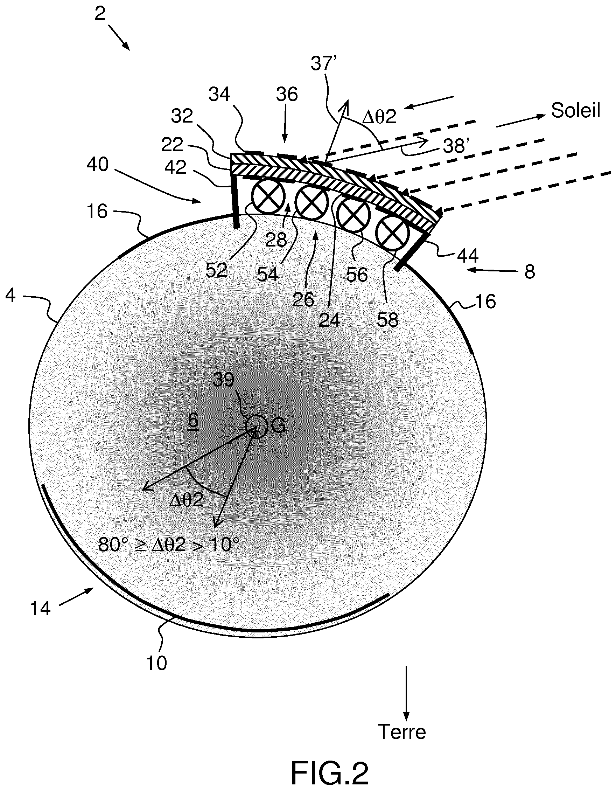

Suivant les Figures 1 et 2 et un premier mode de réalisation, un ballon 2, ici un ballon stratosphérique, comprend une enveloppe 4 en surpression gonflée et contenant un gaz porteur 6, par exemple de l'hélium, et comprend un générateur solaire 8 à concentration de rayonnement solaire.

Le générateur solaire 8 comporte un réflecteur 10 de rayons solaires 12, disposé à l'intérieur de l'enveloppe 4 en une première zone 14 de l'enveloppe, une deuxième zone 16 de l'enveloppe 4, transparente aux rayons solaires, pour laisser passer les rayons solaires 12 vers le réflecteur 10.

L'enveloppe 4 est par exemple en polyuréthane complexe renforcé. La deuxième zone 16 de l'enveloppe 4 peut être réalisée en utilisant pour l'enveloppe des polyuréthanes transparents aux rayons solaires et en évitant de recouvrir la deuxième zone 16 de l'enveloppe par un revêtement empêchant le passage du rayonnement solaire.

Le générateur solaire 8 comporte également un premier ensemble 22 de cellules photovoltaïques mono-faciales 24, disposé en une troisième zone 26 de l'enveloppe 4, les faces actives des cellules étant dirigées et orientées dans le même sens vers le réflecteur 10 et formant une première face active 28 du premier ensemble 22.

La forme de la surface réfléchissante du réflecteur 10 est adaptée pour concentrer les rayons solaires sur les cellules photovoltaïques 24 mono-faciales du premier ensemble 22 et conditionne l'angle de flux du faisceau réfléchi de rayons solaires pour le concentrer sur la surface active des cellules photovoltaïques 24 mono-faciales du premier ensemble 22.

Le réflecteur 10 à concentration peut être réalisé par une toile enduite d'un revêtement réfléchissant et plaquée sur ladite enveloppe en polyuréthane en la première zone 14 de l'enveloppe 4. La concentration géométrique des rayons du soleil sur les cellules photovoltaïques 24 du premier ensemble 22 permet ainsi de réduire la surface du premier ensemble 22 de cellules photovoltaïques 24 de façon significative et par suite la masse associée. L'énergie solaire concentrée passe alors à travers une deuxième portion transparente de l'enveloppe qui correspond à une partie ou la totalité de la troisième zone 26 de l'enveloppe 4.

Le générateur solaire 8 comporte également un deuxième ensemble 32 de cellules photovoltaïques 34, disposé en la troisième zone 26 de l'enveloppe 4 et au-dessus du premier ensemble 22. Les faces actives photovoltaïques des cellules 34 du deuxième ensemble 32 sont dirigées et orientées vers l'extérieur de l'enveloppe 4 et forment une deuxième face active 36 du deuxième ensemble 32.

En variante, le deuxième ensemble de cellules photovoltaïques mono-faciales, est disposé en une quatrième zone, distincte de la troisième zone de l'enveloppe, les faces actives photovoltaïques des cellules du deuxième ensemble étant dirigées et orientées vers l'extérieur de l'enveloppe.

De manière générale, le réflecteur 10, la deuxième zone 16 de l'enveloppe, le premier ensemble 22 de cellules photovoltaïques 24 et le deuxième ensemble 32 de cellules photovoltaïques 34 mono-faciales sont configurés de sorte à assurer une production coopérative d'énergie électrique entre le premier ensemble 22 et le deuxième ensemble 32 de cellules photovoltaïques tant que le dépointage solaire en roulis Δ*θ*1 du réflecteur 10 à concentration est inférieur ou égal en valeur absolue à 10 degrés, un exemple de cette configuration d'éclairement étant représenté sur la Figure 1.

Suivant la Figure 1, le dépointage solaire en roulis Δ*θ*1 du réflecteur 10 à concentration est l'angle formé entre l'axe optique 37 du réflecteur 10 et une direction du soleil actuelle 38

Suivant les Figures 1 et 2, le ballon 2 est supposé avoir un axe 39 de direction longitudinale 39 passant par le centre de gravité G du ballon 2, représenté en bout sur les Figures 1 et 2 et orienté vers l'avant de ces dernières, et autour duquel le ballon 2 peut tourner suivant un angle de roulis θ.

Suivant les Figures 1 et 2, l'attitude en cap du ballon 2 est supposée avoir été réglée de sorte que l'axe optique 37 du réflecteur 10 et la direction de pointage actuelle du ballon 2 vers le soleil forme un plan ayant pour normale la direction longitudinale 39 du ballon 2.

De manière supplémentaire et particulière, le réflecteur 10 à concentration, la deuxième zone 16 de l'enveloppe, le premier ensemble 22 et le deuxième ensemble 32 de cellules solaires mono-faciales sont configurés de sorte à maintenir un éclairement des cellules photovoltaïques 34 du deuxième ensemble 32 tant que le dépointage solaire en roulis Δ*θ*2 de la deuxième face active 36 du deuxième ensemble 32 est inférieure ou égal à 80 degrés, un exemple de cette configuration d'éclairement étant représenté sur la Figure 2.

Suivant la Figure 2, le dépointage solaire en roulis Δ*θ*2 de la deuxième face active 36 du deuxième ensemble 32 est l'angle formé entre la normale de pointage 37' de la deuxième face active 36 du deuxième ensemble 32 et une direction du soleil actuelle 38'.

Les premier et deuxième ensembles 22, 32 sont disposés au-dessus et à l'extérieur de l'enveloppe en la même troisième zone 26.

Les premier et deuxième ensembles 22, 32 sont tous deux superposés, le deuxième ensemble 32 étant disposé le plus à l'extérieur de l'enveloppe 4 et les première et deuxième faces actives 28, 36 des premier et deuxième ensembles 22, 32 étant orientées dans des directions opposées.

Le refroidissement des cellules photovoltaïques 24, 34 des premier et deuxième ensembles 22, 32 est favorisé puisque réchauffement des cellules photovoltaïques a lieu en extérieur et bénéficie ainsi d'une ventilation naturelle ou forcée.

Le découplage thermique entre d'une part les premier et deuxième ensembles 22, 32 de cellules photovoltaïques et d'autre part l'enveloppe 4 et le gaz porteur 6 que l'enveloppe 4 contient est réalisé par une structure de support et d'écartement 40 des ensembles 22, 32 des cellules solaires 24, 34 de l'enveloppe 4.

Ici sur les Figures 1 et 2, deux poteaux 42, 44 représentent partiellement cette structure de support et d'écartement 40. La structure de support 40 est fixée sur l'enveloppe 4 en la troisième zone 26 et les premier et deuxième ensembles 22, 32 des cellules photovoltaïques mono-faciales 24, 34 sont fixés sur la structure de support 40. Un espace 48, délimité par l'enveloppe 4, la structure 40 et l'ensemble des cellules 24, 34 forme un canal de circulation d'air pour refroidir les cellules 24, 34 par convection naturelle ou forcée.

Ici, sur les Figures 1 et 2 la convection est forcée et assurée par quatre ventilateurs 52, 54, 56, 58

En outre, la structure de support et d'écartement 40 est déformable pour absorber les déformations thermomécaniques de l'enveloppe et/ou maintenir un écart suffisant entre l'enveloppe et l'ensemble des cellules pour permettre le refroidissement des cellules.

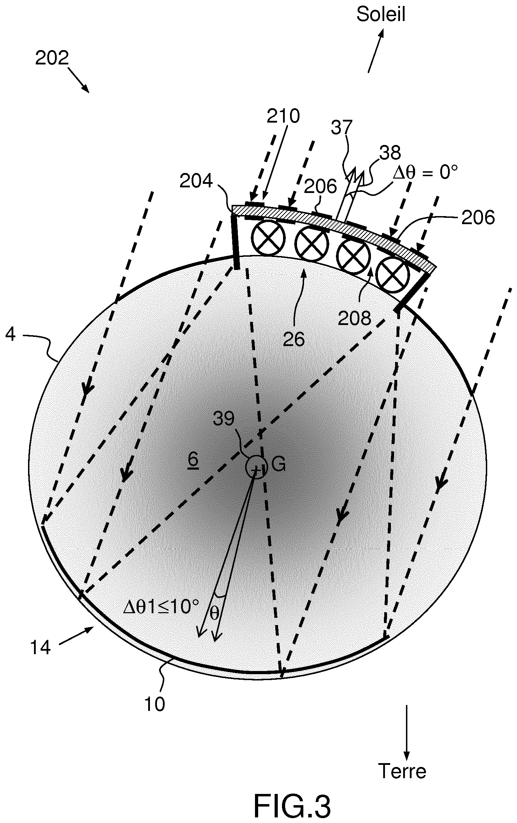

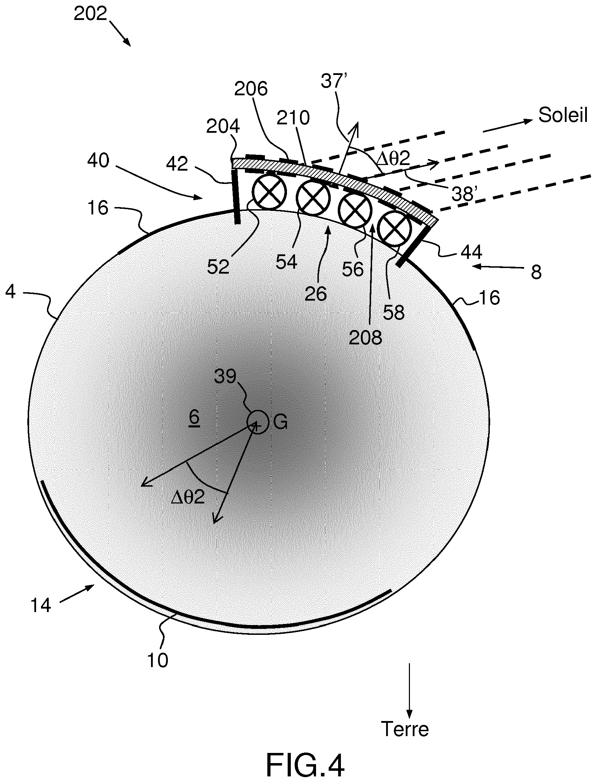

Suivant les Figure 3 et 4 et un deuxième mode de réalisation du ballon selon l'invention, un ballon 202 équipé d'un générateur solaire à concentration présente une architecture similaire à celle du ballon 2 des Figures 1 et 2. Les configurations d'attitude du ballon 202 et d'éclairement du ballon par le soleil concernant les Figures 3 et 4 sont respectivement les mêmes que celles des Figures 1 et 2.

Le ballon 202 diffère du ballon 2 en ce que les premier et deuxième ensembles 22, 32 de cellules photovoltaïques forment un même unique ensemble 204 de cellules photovoltaïques bifaciales 206, situé au dessus de la troisième zone 26 de l'enveloppe.

L'ensemble 204 des cellules solaires bifaciales 206 comporte une première face active 208, orientée vers le réflecteur concentrateur 10, et une deuxième face active 210, orientée vers l'extérieur de l'enveloppe 4 et ayant une direction de pointage opposée à celle de la première face 208.

De manière générale, le réflecteur 10 à concentration, la deuxième zone 16 de l'enveloppe 4, la première face active 208 et la deuxième face active 210 de l'ensemble 204 des cellules photovoltaïques bifaciales 206 sont configurés de sorte à assurer une production coopérative d'énergie électrique entre les première et deuxième faces actives 208, 210 de l'ensemble 204 de cellules photovoltaïques bifaciales tant que le dépointage solaire en roulis Δ*θ*1 du réflecteur 10 à concentration est inférieur ou égal en valeur absolue à 10 degrés, un exemple de cette configuration d'éclairement étant représenté sur la Figure 3.

De manière supplémentaire et particulière, le réflecteur concentrateur 10, la deuxième zone 16 de l'enveloppe, la première face active 208 et la deuxième face active 210 de l'ensemble 204 des cellules solaires bifaciales sont configurés de sorte à maintenir un éclairement de la deuxième face active 210 de l'ensemble 204 tant que le dépointage solaire en roulis Δ*θ*2 de la deuxième face active 210 de l'ensemble 204 est inférieur ou égal à 80 degrés, un exemple de cette configuration d'éclairement étant représenté sur la Figure 4.

A l'instar du ballon 2 des Figures 1 et 2, l'ensemble 204 des cellules solaires bifaciales 206 est découplé thermiquement de l'enveloppe 4 et du gaz porteur 6 que l'enveloppe 4 contient par la structure de support et d'écartement 40. Le découplage des cellules solaires de l'enveloppe du ballon permet un refroidissement des cellules solaires bifaciales par convection naturelle ou forcée, ce qui entraine une meilleure efficacité des cellules solaires, cette dernière étant plus élevée à basse température.

Suivant les Figures 3 et 4, la convection est ici forcée et assurée par les quatre ventilateurs 52, 54, 56, 58

En outre, la structure de support et d'écartement 40 est déformable pour absorber les déformations thermomécaniques de l'enveloppe 4 et/ou maintenir un écart suffisant entre l'enveloppe 4 et l'ensemble 204 des cellules solaires bifaciales 206 pour permettre le refroidissement des cellules.

La technologie de fabrication des cellules bifaciales 206 est une technologie comprise dans l'ensemble formé par la technologie silicium PERT (Passivated Emitter Rear Totally Diffused), la technologie silicium à hétérojonction HTJ (Heterojunction), et la technologie silicium IBC (Interdigitated Back Contact).

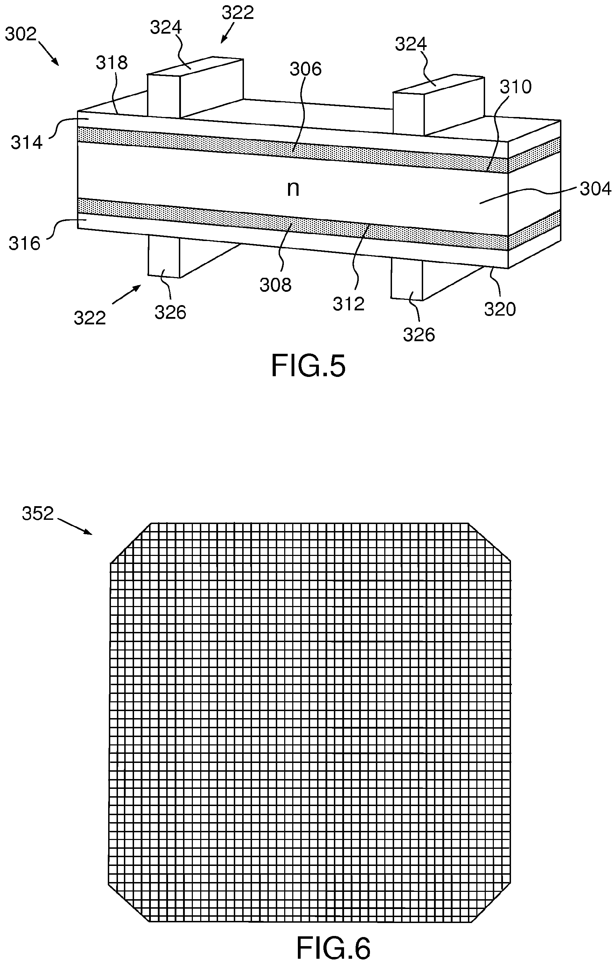

Suivant la Figure 5 et une structure classique de cellule solaire bifaciale utilisant une technologie silicium à hétérojonction, une cellule solaire ou photovoltaïque bifaciale 302 comporte un ensemble de couches superposées.

La cellule solaire 302 comporte une couche centrale 304 formant substrat de silicium monocristallin type (n) de haute qualité sur laquelle sont déposées des couches de silicium amorphe 306, 308 d'épaisseur nanométrique en une première face 310 et une deuxième face 312 pour créer la jonction et ainsi assurer une passivation de surface excellente. Sur les couches de silicium amorphe 306, 308 sont déposées des couches d'oxydes transparents 314, 316 qui assurent la conduction latérale des charges et permettent un meilleur confinement optique. Sur les faces 318, 320 sont déposés un composé métallique 322 formant respectivement un premier peigne d'électrodes 324 (en anglais gridfingers) et un deuxième peigne d'électrodes 326 afin d'assurer une collection efficace des charges générées.

Ainsi cette structure symétrique de la cellule solaire 302 permet une illumination par les deux faces ou côtés et une activité électrique des deux faces.

De manière préférée, la technologie de fabrication et de connexion des cellules bifaciales est une technologie de fabrication de cellules photovoltaïques bifaciales à hétérojonction combinée à la technologie de connexion SmartWire ou SWCT.

Suivant le procédé SWCT, des fils métalliques sont enchâssés dans une feuille de polymère qui est appliquée directement sur la surface métallisée de la cellule solaire. Ensuite, l'ensemble formé par la cellule solaire et la feuille polymère incrustée par les fils métallisés est laminé. Les fils métalliques sont ainsi fixés sur la couche métallisée de la cellule et forme un contact électrique.

En augmentant le nombre de barres de bus (en anglais busbars) traversant la cellule solaire bifaciale sur chacune de ses faces et en réduisant l'épaisseur desdites barres de bus, un meilleur compromis est trouvé entre la diminution des pertes ohmiques des peignes d'électrodes et la diminution des ombrages de la surface de la cellule solaire.

L'utilisation de la technologie de connexion SmartWire ou SWCT est le résultat ultime de cette évolution en distribuant la métallisation sur toute la surface de la cellule solaire comme illustré par une cellule typique 352 sur la Figure 6.

De manière avantageuse, l'utilisation de la technologie SWCT qui est compatible d'une technologie silicium à hétérojonction HTJ, diminue la résistance et l'ombrage de la cellule solaire, répartit les contraintes mécaniques sur toute la surface de la cellule, et augmente la tenue des connexions après des cycles thermiques par rapport à une technologie utilisant des barres de bus.

De manière préférée, les cellules solaires du type de la cellule solaire 352 sont interconnectées entre elles sur une même face active de l'ensemble en évitant que des traversées de connexions entre la face d'une première cellule située du même côté que la première face de l'ensemble et la face d'une deuxième cellule, adjacente à la première cellule, située du même coté que la deuxième face de l'ensemble ne soit effectuée.

Un procédé d'interconnexion dit planaire de cellules solaires bifaciales à hétérojonction comprend une première étape et une deuxième étape.

Dans la première étape, les cellules bifaciales à hétérojonction d'une même chaîne de cellules prévues pour être reliées électriquement en série sont agencées entre elles de sorte à réaliser sur la première face active de l'ensemble une première distribution alternée d'une première polarité et d'une deuxième polarité, chaque cellule bifaciale ayant une première face associée à la première polarité et une deuxième face ayant une deuxième polarité. De manière complémentaire en termes de polarités, pour la même chaîne de cellules solaires une deuxième distribution alternée de la deuxième polarité et la première polarité est réalisée sur la deuxième face active de l'ensemble.

Puis, dans la deuxième étape, pour chaque face de l'ensemble des cellules bifaciales, une interconnexion planaire des cellules entre elles sur la même face est réalisé suivant l'agencement des cellules prévus pour former une ou plusieurs chaines sans avoir recours à des interconnexions traversant l'ensemble en épaisseur d'une de ses face actives à l'autre.

Les interconnexions planaires diminuent les risques de dommages lors de cycles thermiques et simplifient le procédé de fabrication de l'ensemble des cellules solaires bifaciales
De manière avantageuse, le procédé d'interconnexion planaire et le procédé de mise en œuvre de la technologie SWCT peuvent être combinés en réalisant l'étape de laminage de la technologie SWCT et la deuxième étape d'interconnexion proprement dite du procédé d'interconnexion en même temps lors d'une phase de cuisson partagée.

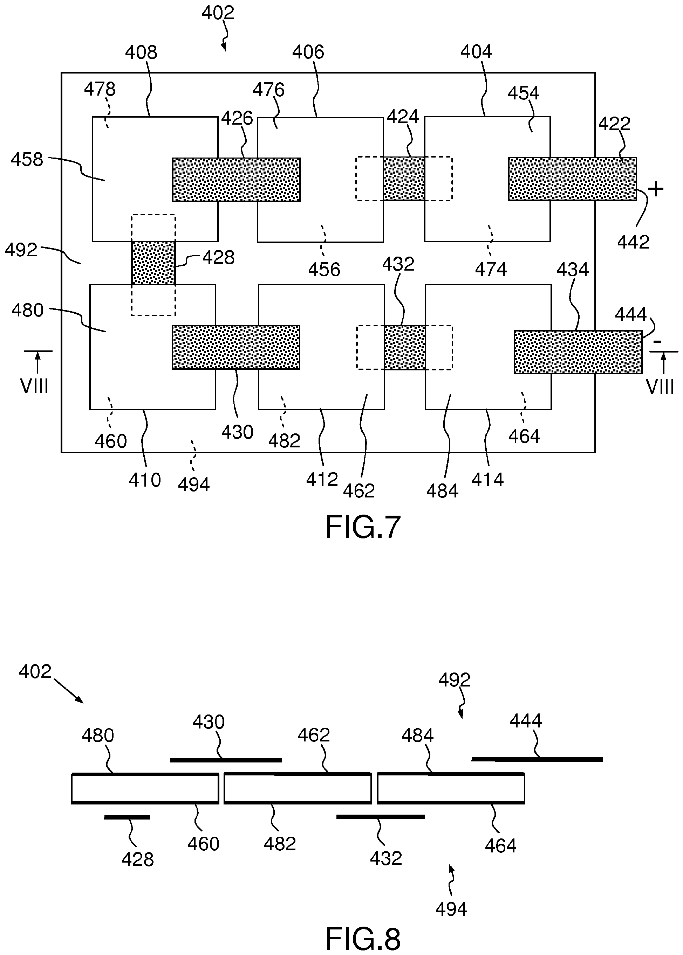

Suivant la Figure 7 et un exemple de schéma d'interconnexion de cellules, un ensemble 402 de cellules solaires bifaciales comprend un certain nombre de cellules solaires bifaciales, ici six cellules solaires 404, 406, 408, 410, 412, 414, reliées entres elles par des rubans métalliques 422, 424, 426, 428, 430, 432, 434 pour former ici une chaîne de cellules photovoltaïques reliées électriquement en série entre une première borne électrique 442 à une première polarité, ici positive, et une deuxième borne électrique 444 à une deuxième polarité, ici négative.

Chaque cellule solaire bifaciale 404, 406, 408, 410, 412, 414 comporte respectivement une première face 454, 456, 458, 460, 462, 464 à la première polarité et une deuxième face 474, 476, 478, 480, 482, 484 à la deuxième polarité.

Les rubans 422, 424, 426, 428, 430, 432, 434 relient respectivement la première borne électrique 422, la deuxième face 474, la deuxième face 476, la deuxième face 478, la deuxième face 480, la deuxième face 482, la deuxième face 484 à la première face 454, la première face 456, la première face 458, la première face 460, la première face 462, la première face 464 et à la deuxième borne électrique 444.

Ainsi, la force électromotrice engendrée par la mise en série des cellules solaires entre la première borne électrique et la deuxième borne électrique est égale à somme des forces électromotrices des cellules solaires 404, 406, 408, 410, 412 et 414.

L'ensemble 402 des cellules solaires forme un panneau ou une nappe de cellules solaires ayant des rayons de courbure nettement plus grands que la taille d'une cellule solaire, le panneau ou la nappe ayant une première face 492 destinée à être orientée vers l'extérieur du ballon et illuminée directement par le soleil, et une deuxième face 494 destinée à être orientée vers l'intérieur du ballon et illuminée par le réflecteur à concentration.

Suivant la Figure 8, le schéma d'interconnexion des cellules solaires 410, 412 et 414 formant une partie de l'unique chaîne de l'ensemble 402 de la Figure 7 est représenté et mis en évidence par une coupe partielle de l'ensemble 402.

Il apparait clairement sur cette Figure 8 l'absence d'interconnexions entre cellules traversant l'ensemble en épaisseur d'une face active à l'autre.

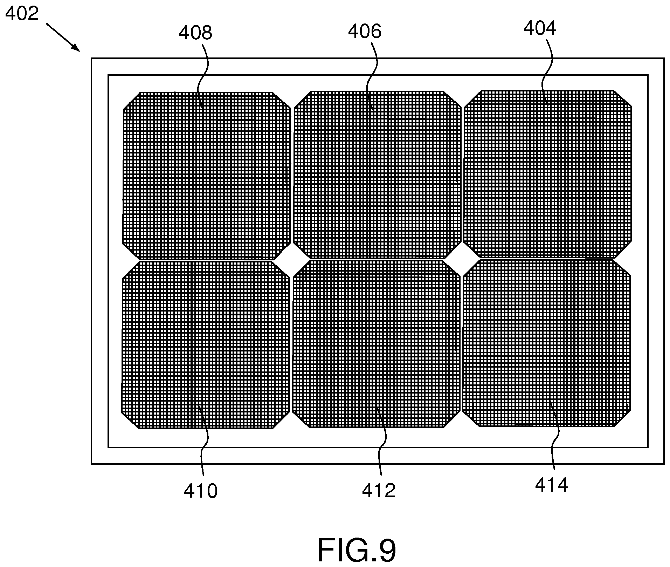

Suivant la Figure 9, une vue réelle de dessus montre l'ensemble 402 des cellules solaires 404, 406, 408, 410, 412, 414 interconnectées entre elles suivant le schéma d'interconnexion décrit dans les Figures 7 et 8.

Il est à remarquer que de manière générale l'ensemble des cellules solaires bifaciales n'est pas limité à une unique chaine de cellules solaires.

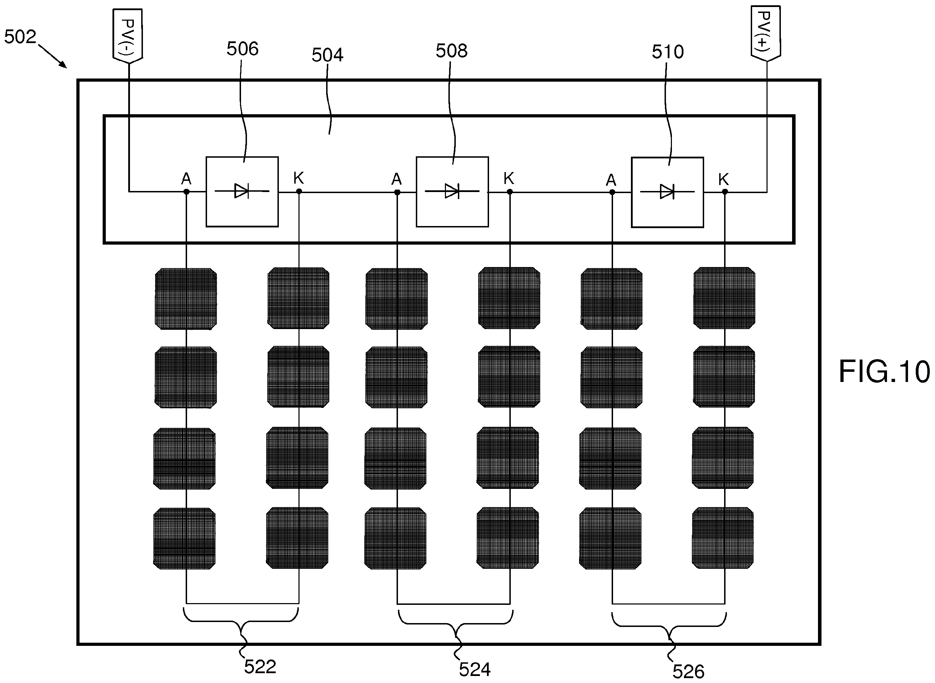

Suivant la Figure 10 et un exemple d'ensemble de cellules solaires bifaciales, un ensemble 502 des cellules photovoltaïques comporte une pluralité 504 d'interrupteurs électroniques de protection 506, 508, 510 ayant chacun au moins une jonction formant diode.

La pluralité 504 d'interrupteurs électroniques de protection 506, 508, 510 est configurée pour protéger une ou plusieurs cellules photovoltaïques 522, 524, 526 contre une montée en température consécutive à des défauts d'uniformité d'illumination de la première face active de l'ensemble 502 par le réflecteur concentrateur.

Les interrupteurs électroniques sont par exemple des diodes discrètes ou des transistors ou des associations de diodes et/ou de transistors.

Il est à remarquer qu'en supplément de l'effet modérateur au réchauffement apporté par l'utilisation d'un deuxième ensemble de cellules solaires mono-faciales ou d'une deuxième face active d'un unique ensemble de cellules solaires bifaciales en raison de sa contribution à la fourniture d'une énergie électrique iso-puissance suivant un pointage de référence nominal, il peut être prévu dans une variante des modes de réalisation décrit ci-dessus, une seconde peau pour protéger l'enveloppe, dans la mesure où celle-ci reçoit un faisceau concentré de rayons solaires. Des films de polyuréthanes particuliers peuvent être utilisés à cet effet.

Quelle que soit la variante utilisée, la zone réfléchissante de la deuxième zone de l'enveloppe, peut avoir la forme de l'enveloppe : dans ce cas la forme de l'enveloppe est choisie de façon à optimiser à la fois la portance du ballon et la convergence optique des rayons solaires vers les cellules photovoltaïques.

Selon une variante de l'invention, l'enveloppe peut comprendre une première peau et une seconde peau comprenant la zone réfléchissante du réflecteur, de façon à pouvoir avoir une forme différente de celle de l'enveloppe. Dans ce cas, la forme de l'enveloppe et celle de la surface réfléchissante du réflecteur peuvent être choisies indépendamment. La forme de l'enveloppe peut être adaptée pour optimiser la portance, la forme de la surface réfléchissante étant choisie pour des raisons optiques seulement. Dans ce cas et avantageusement, la zone réfléchissante peut être déformable, de façon à optimiser sa forme en tenant compte également de l'angle d'incidence des rayons solaires. Cet angle peut varier en fonction de l'heure de la journée, de la saison, de l'altitude et de la position géographique du ballon.

De manière générale, la forme de l'enveloppe est préférablement de révolution. Une forme ellipsoïde pour l'enveloppe est adaptée pour assurer une portance et une performance optique satisfaisantes, en particulier si la surface réfléchissante est la même que celle de l'enveloppe. Alternativement l'enveloppe peut être de forme parabolique.

Les formes habituelles des ballons pouvant être aussi bien sphériques que paraboliques, peuvent être utilisées, en particulier si la forme de la zone réfléchissante est indépendante de la forme de l'enveloppe.

La forme de la zone réfléchissante est préférablement parabolique.

De manière générale, la configuration de l'enveloppe conduit à conférer à la zone réfléchissante qui en fait partie un pouvoir de concentration des rayons solaires en direction des cellules photovoltaïques. Le facteur de concentration peut être ajustable, typiquement il peut être supérieur à 1 et inférieur à 5, variant avec l'heure du jour, puisque l'angle θ des rayons solaires varie avec l'heure du jour.

De manière générale pour tous les modes de réalisation du ballon selon l'invention, en cas de pointage nominal les cellules solaires sont illuminées par concentration depuis l'intérieur du ballon et depuis l'extérieur du ballon par le rayonnement direct du Soleil, ce qui à iso-puissance électrique produite par rapport à une solution utilisant un concentrateur seul permet de limiter la puissance rayonnante du concentrateur qui est une source potentielle d'un risque d'endommagement du ballon en raison d'un possible échauffement de l'enveloppe et/ou du gaz porteur contenu dans l'enveloppe.

En cas de dépointage suffisant en roulis, c'est-à-dire au-delà d'environ 10 degrés, les cellules solaires configurées pour recevoir le rayonnement du concentrateur ne seront plus illuminés par l'intérieur du ballon mais celles orientées vers l'extérieur du ballon seront toujours illuminés directement par le soleil tant que le dépointage en roulis du ballon reste en-dessous de 80 degrés, ce qui permet de limiter l'utilisation du système de stockage d'énergie à bord, par exemple une pile à combustible. En outre, ce système est plus robuste à tout dépointage en lacet, c'est-à-dire un changement de cap.

L'avantage de cette solution est qu'en cas de dépointage, même si la concentration n'est pas opérationnelle la face orientée directement vers le soleil est toujours opérationnelle, notamment pendant les phases de transition, de manœuvres du ballon.

Pour obtenir les mêmes résultats et performances, les cellules bifaciales peuvent être remplacées par un couple de cellules solaires mono-faciales, voire les deux fonctions du générateur solaire, avec concentration interne et sans concentration externe peuvent être dissociées en étant disposées sur des emplacements différents.

Ces solutions sont sous-optimales par rapport à la solution utilisant des cellules bifaciales car dans ces cas le nombre total de cellules solaires formant les deux réseaux est pratiquement doublé, ce qui entraine une masse plus grande et une augmentation de la complexité.

De manière générale, le ballon stratosphérique décrit ci-dessus peut être remplacé par n'importe quel autre type de ballon évoluant dans d'autres couches de l'atmosphère, en conservant à l'identique les caractéristiques de l'invention.

## Revendications

1. Ballon équipé d'un générateur solaire à concentration comprenant une enveloppe (4) contenant un gaz porteur (6) et un générateur solaire (8) à concentration de rayonnement solaire,
le générateur solaire (8) comportant
un réflecteur (10) de rayons solaires, disposé à l'intérieur de l'enveloppe (4) en une première zone (14) de l'enveloppe (4),
Une deuxième zone (16) de l'enveloppe (4), transparente aux rayons solaires, pour laisser passer les rayons solaires vers le réflecteur (10), et
un premier ensemble (22 ; 204) de cellules photovoltaïques (24 ; 206), disposé en une troisième zone (26) de l'enveloppe, ayant une première face active (28 ; 208) dirigée vers le réflecteur (10);
le premier ensemble (22 ; 204) de cellules photovoltaïques (24 ; 206) et le réflecteur (10) étant configurés de sorte que le réflecteur (10) concentre les rayons solaires sur la première face active (28 ; 208) du premier ensemble (22 ; 204) de cellules photovoltaïques (24 ; 206), lorsque le réflecteur (10) est mis en position de pointage solaire ;
le générateur solaire (8) comportant en outre un deuxième ensemble (32) de cellules photovoltaïques, disposé en une quatrième zone de l'enveloppe ou en la troisième zone (26) de l'enveloppe, et ayant une deuxième face active dirigée vers l'extérieur de l'enveloppe (4) ; ou
le générateur solaire (8) comportant un seul premier ensemble (204) dont les cellules solaires sont des cellules solaires bifaciales et le premier ensemble (204) comporte une deuxième face active (36) dirigée vers l'extérieur de l'enveloppe (4) ; et
le réflecteur (10), le premier ensemble (204) seul des cellules photovoltaïques bifaciales (206) ou les premier et deuxième ensembles (22, 32) des cellules photovoltaïques (24, 34) étant configurés de sorte à assurer une production coopérative d'énergie électrique entre la première face active (28 ; 208) et la deuxième face active (36 ; 210) tant que le dépointage solaire en roulis du réflecteur (10) est inférieur ou égal en valeur absolue à 10 degrés ;
le ballon étant **caractérisé en ce que**
la deuxième zone (16) de l'enveloppe, transparente aux rayons solaires, entoure partiellement ou complètement la troisième zone (26) d'emplacement du premier ensemble de cellules photovoltaïques destinées à recevoir les rayons solaires du réflecteur, et
la surface de la deuxième zone (16) est ajustée pour assurer un éclairement suffisant des cellules photovoltaïques du premier ensemble et pour éviter un échauffement excessif des cellules solaires et/ou de l'enveloppe (4) et/ou du gaz porteur (6) que l'enveloppe (4) contient.

2. Ballon équipé d'un générateur solaire à concentration selon la revendication 1, dans lequel le réflecteur (10), le premier ensemble (204) seul de cellules photovoltaïques bifaciales (206) ou les premier et deuxième ensembles (22, 32) de cellules photovoltaïques (24, 34) sont configurés de sorte à maintenir un éclairement de la deuxième face active (36 ; 210) tant que le dépointage solaire en roulis de la deuxième face active (36 ; 210) est inférieur ou égal à 80 degrés.

3. Ballon équipé d'un générateur solaire à concentration selon l'une quelconque des revendications 1 à 2 dans lequel
Les premier et deuxième ensembles de cellules photovoltaïques (22, 32) sont distincts et disposés respectivement en des troisième et quatrième zones différentes.

4. Ballon équipé d'un générateur solaire à concentration selon l'une quelconque des revendications 1 à 2, dans lequel
Les premier et deuxième ensembles de cellules photovoltaïques (22, 32) sont distincts et comportent chacun des cellules photovoltaïques mono-faciales ; et
Les premier et deuxième ensembles sont disposés sur et à l'extérieur de l'enveloppe en la même zone (26);
Les premier et deuxième ensembles (22, 32) sont mutuellement superposés, le deuxième ensemble (32) étant disposé le plus à l'extérieur de l'enveloppe (4) et les faces actives des cellules photovoltaïques des premier et deuxième ensembles (22, 32) étant orientés dans des directions opposées.

5. Ballon d'un générateur solaire à concentration selon l'une quelconque des revendications 1 à 4, dans lequel le premier ensemble (22) et le deuxième ensemble (32) sont découplés mécaniquement de l'enveloppe en termes de déformations de l'enveloppe et/ou thermiquement de l'enveloppe et du gaz porteur que l'enveloppe contient.

6. Ballon équipé d'un générateur solaire à concentration selon l'une quelconque des revendications 1 à 2, dans lequel
Le premier ensemble (204) de cellules photovoltaïques est un ensemble de cellules photovoltaïques bifaciales (206) situé au dessus de la troisième zone (26) de l'enveloppe (4),
Chaque cellule bifaciale (206) comportant une première face associée à une première polarisation électrique et une deuxième face associée à une deuxième polarisation électrique.

7. Ballon équipé d'un générateur solaire à concentration selon la revendication 6, dans lequel la technologie de fabrication des cellules bifaciales (206) est une technologie comprise dans l'ensemble formé par la technologie silicium PERT (Passivated Emitter Rear Totally Diffused), la technologie silicium à hétérojonction HTJ (Heterojunction), et la technologie silicium IBC (Interdigitated Back Contact).

8. Ballon équipé d'un générateur solaire à concentration selon la revendication 7, dans lequel la technologie de fabrication et de connexion des cellules bifaciales (206) est une technologie de fabrication de cellules photovoltaïques bifaciales à hétérojonction combinée à la technologie de connexion SmartWire ou SWCT.

9. Ballon équipé d'un générateur solaire à concentration selon l'une quelconque des revendications 7 à 8, dans lequel les cellules bifaciales (206) sont des cellules photovoltaïques bifaciales à hétérojonction,
agencées entre elles de manière à réaliser une ou plusieurs chaîne de cellules solaires reliées électriquement en série et à permettre une interconnexion planaire des cellules entre elles sur la même face sans avoir recours à des interconnexions traversant l'ensemble (204) en épaisseur d'une de ses faces (208, 210) à l'autre.

10. Ballon équipé d'un générateur solaire à concentration selon l'une quelconque des revendications 6 à 9, dans lequel l'ensemble (502) des cellules photovoltaïques comporte une pluralité (504) d'interrupteurs électroniques de protection (506, 508, 510) ayant chacun au moins une jonction formant diode pour protéger une ou plusieurs cellules photovoltaïques pour protéger la ou les cellules contre une montée en température consécutive à des défauts d'uniformité d'illumination des deuxièmes faces actives par le réflecteur.

11. Ballon équipé d'un générateur solaire à concentration selon l'une quelconque des revendications 6 à 10, dans lequel
l'ensemble (204) des cellules photovoltaïques bifaciales (206) est découplé thermiquement de l'enveloppe (4) et du gaz porteur (6) que l'enveloppe (4) contient par une structure de support et d'écartement (40) de l'ensemble des cellules de l'enveloppe,
la structure de support et d'écartement (40) étant fixée sur l'enveloppe en la troisième zone (26) et l'ensemble (204) des cellules solaires bifaciales (206) étant fixé sur la structure de support et d'écartement (40),
et l'espace (48) délimité par l'enveloppe (4), la structure (40) et l'ensemble (204) des cellules formant un canal de circulation d'air pour refroidir les cellules solaires bifaciales (206) par convection naturelle ou forcée.

12. Ballon équipé d'un générateur solaire à concentration selon la revendication 11, comportant un ou plusieurs ventilateurs (52, 54, 56, 58) pour faire circuler de l'air dans le canal et refroidir l'ensemble (204) des cellules photovoltaïques (206).

13. Ballon équipé d'un générateur solaire à concentration selon l'une quelconque des revendications 11 à 12, dans lequel la structure de support et d'écartement (40) est déformable pour absorber les déformations thermomécaniques de l'enveloppe et/ou maintenir un écart suffisant entre l'enveloppe et l'ensemble des cellules pour permettre le refroidissement des cellules.

## Patentansprüche

1. Ballon, ausgestattet mit einem Solargenerator mit Konzentration, der eine Hülle (4) umfasst, die ein Trägergas (6) und einen Solargenerator (8) mit Konzentration von Solarstrahlung enthält,
wobei der Solargenerator (8) Folgendes umfasst:
einen Solarstrahlenreflektor (10), der im Innern der Hülle (4) in einer ersten Zone (14) der Hülle (4) angeordnet ist;
eine zweite Zone (16) der Hülle (4), die für die Solarstrahlen transparent ist, so dass die Solarstrahlen in Richtung des Reflektors (10) durchgelassen werden; und
einen ersten Satz (22; 204) von fotovoltaischen Zellen (24; 206), in einer dritten Zone (26) der Hülle angeordnet, mit einer ersten aktiven Fläche (28; 208), die auf den Reflektor (10) gerichtet ist;
wobei der erste Satz (22; 204) von fotovoltaischen Zellen (24; 206) und der Reflektor (10) so konfiguriert sind, dass der Reflektor (10) die Solarstrahlen auf der ersten aktiven Fläche (28; 208) des ersten Satzes (22; 204) von fotovoltaischen Zellen (24; 206) konzentriert, wenn der Reflektor (10) in einer Solarausrichtungsposition ist;
wobei der Solargenerator (8) ferner einen zweiten Satz (32) von fotovoltaischen Zellen umfasst, angeordnet in einer vierten Zone der Hülle oder in der dritten Zone (26) der Hülle, und mit einer zweiten aktiven Fläche, die zur Außenseite der Hülle (4) hin gerichtet ist; oder
wobei der Solargenerator (8) einen einzelnen ersten Satz (204) umfasst, dessen Solarzellen bifaciale Solarzellen sind, und der erste Satz (204) eine zweite aktive Fläche (36) umfasst, die zur Außenseite der Hülle (4) hin gerichtet ist; und
wobei der Reflektor (10), der erste Satz (204) nur der bifacialen fotovoltaischen Zellen (206) oder der erste und zweite Satz (22, 32) von fotovoltaischen Zellen (24, 34) so konfiguriert sind, dass sie eine kooperative Produktion von elektrischer Energie zwischen der ersten aktiven Fläche (28; 208) und der zweiten aktiven Fläche (36; 210) bereitstellen, solange die abrollende Solarfehlausrichtung des Reflektors (10) gleich oder kleiner als 10 Grad als Absolutwert ist;
wobei der Ballon **dadurch gekennzeichnet ist, dass**:
die zweite Zone (16) der Hülle, die für Solarstrahlen transparent ist, die dritte Ortszone (26) des ersten Satzes von fotovoltaischen Zellen ganz oder teilweise umgibt, der die Solarstrahlen des Reflektors aufnehmen soll; und
die Oberfläche der zweiten Zone (16) so justiert ist, dass sie eine ausreichende Beleuchtung der fotovoltaischen Zellen des ersten Satzes bereitstellt und eine zu starke Erhitzung der Solarzellen und/oder der Hülle (4) und/oder des Trägergases (6) vermeidet, das die Hülle (4) enthält.

2. Ballon, ausgestattet mit einem Solargenerator mit Konzentration nach Anspruch 1, wobei der Reflektor (10), der erste Satz (204) nur von bifacialen fotovoltaischen Zellen (206) oder der erste und zweite Satz (22, 32) von fotovoltaischen Zellen (24, 34) so konfiguriert sind, dass die Beleuchtung der zweiten aktiven Fläche (36; 210) beibehalten wird, solange die abrollende Solarfehlausrichtung der zweiten aktiven Fläche (36; 210) gleich oder kleiner als 80 Grad ist.

3. Ballon, ausgestattet mit einem Solargenerator mit Konzentration nach einem der Ansprüche 1 bis 2, wobei
der erste und zweite Satz von fotovoltaischen Zellen (22, 32) separat und jeweils in einer dritten und vierten unterschiedlichen Zone angeordnet sind.

4. Ballon, ausgestattet mit einem Solargenerator mit Konzentration nach einem der Ansprüche 1 bis 2, wobei
der erste und zweite Satz von fotovoltaischen Zellen (22, 32) separat sind und jeweils monofaciale fotovoltaische Zellen umfassen; und
der erste und zweite Satz auf und außerhalb der Hülle in derselben Zone (26) angeordnet sind;
der erste und zweite Satz (22, 32) sich gegenseitig überlagern, wobei der zweite Satz (32) am weitesten außerhalb der Hülle (4) ist und wobei die aktiven Flächen der fotovoltaischen Zellen des ersten und zweiten Satzes (22, 32) in entgegengesetzten Richtungen orientiert sind.

5. Ballon eines Solargenerators mit Konzentration nach einem der Ansprüche 1 bis 4, wobei der erste Satz (22) und der zweite Satz (32) mechanisch von der Hülle im Hinblick auf Verformungen der Hülle separat und/oder thermisch von der Hülle und von dem Trägergas separat sind, den die Hülle enthält.

6. Ballon, ausgestattet mit einem Solargenerator mit Konzentration nach einem der Ansprüche 1 bis 2, wobei
der erste Satz (204) von fotovoltaischen Zellen ein Satz von bifacialen fotovoltaischen Zellen (206) ist, die sich über der dritten Zone (26) der Hülle (4) befinden,
jede bifaciale Zelle (206) eine mit einer ersten elektrischen Polarisation assoziierte erste Fläche und eine mit einer zweiten elektrischen Polarisation assoziierte zweite Fläche aufweist.

7. Ballon, ausgestattet mit einem Solargenerator mit Konzentration nach Anspruch 6, wobei die Technologie zur Herstellung der bifacialen Zellen (26) eine Technologie ist, die in die Gruppe bestehend aus PERT-(Passivated Emitter Rear Totally Diffused)-Siliciumtechnologie, HTJ-(Heterojunction)-Heteroübergangssiliciumtechnologie und IBC-(Interdigitated Back Contact)-Siliciumtechnologie fällt.

8. Ballon, ausgestattet mit einem Solargenerator mit Konzentration nach Anspruch 7, wobei die Herstellungs- und Verbindungstechnologie für die bifacialen Zellen (26) eine Technologie zur Herstellung von bifacialen fotovoltaischen Heteroübergangszellen in Kombination mit der SmartWire- oder SWCT-Verbindungstechnologie ist.

9. Ballon, ausgestattet mit einem Solargenerator mit Konzentration nach einem der Ansprüche 7 bis 8, wobei die bifacialen Zellen (206) bifaciale fotovoltaische Heteroübergangszellen sind,
relativ zueinander so angeordnet, dass sie eine oder mehrere Ketten von Solarzellen produzieren, die elektrisch in Serie geschaltet sind, und um eine planare Verbindung der Zellen untereinander auf derselben Fläche zuzulassen, ohne Verbindungen benutzen zu müssen, die durch die Dicke der Baugruppe (204) von einer ihrer Flächen (208, 210) zur anderen passieren.

10. Ballon, ausgestattet mit einem Solargenerator mit Konzentration nach einem der Ansprüche 6 bis 9, wobei der Satz (502) von fotovoltaischen Zellen eine Merhzahl (504) von elektronischen Schutzschaltern (506, 508, 510) jeweils mit mindestens einem Diodeübergang zum Schützen von einer oder mehreren fotovoltaischen Zellen zum Schützen der ein oder mehreren Zellen vor einer Temperaturerhöhung nach Beleuchtungsgleichmäßigkeitsdefekten in zweiten aktiven Flächen durch den Reflektor umfasst.

11. Ballon, ausgestattet mit einem Solargenerator mit Konzentration nach einem der Ansprüche 6 bis 10, wobei
der Satz (204) von bifacialen fotovoltaischen Zellen (206) thermisch von der Hülle (4) und dem Trägergas (6), das die Hülle (4) enthält, durch eine Trag- und Trennstruktur (40) für den Satz von Zellen der Hülle getrennt ist,
wobei die Trag- und Trennstruktur (40) an der Hülle in der dritten Zone (26) befestigt ist und der Satz (204) von bifacialen Solarzellen (26) an der Trag- und Trennstruktur (40) befestigt ist,
und der durch die Hülle (4) begrenzte Raum (48), die Struktur (40) und der Satz (214) von Zellen einen Luftzirkulationskanal zum Kühlen der bifacialen Solarzellen (206) durch natürliche oder Zwangskonvektion bilden.

12. Ballon, ausgestattet mit einem Solargenerator mit Konzentration nach Anspruch 11, der einen oder mehrere Lüfter (52, 54, 56, 58) zum Zirkulieren von Luft in dem Kanal und zum Kühlen des Satzes (204) von fotovoltaischen Zellen (206) umfasst.

13. Ballon, ausgestattet mit einem Solargenerator mit Konzentration nach einem der Ansprüche 11 bis 12, wobei die Trag- und Trennstruktur (40) verformbar ist, um die thermomechanischen Verformungen der Hülle zu absorbieren und/oder um eine ausreichende Lücke zwischen der Hülle und dem Satz von Zellen zu halten, damit die Zellen gekühlt werden können.

## Claims

1. A balloon equipped with a solar generator with concentration comprising an envelope (4) containing a carrier gas (6) and a solar generator (8) with concentration of solar radiation,
the solar generator (8) comprising:
- a solar radiation reflector (10) disposed inside the envelope (4) in a first zone (14) of the envelope (4);
- a second zone (16) of the envelope (4), transparent to the solar radiation, for allowing through the solar radiation towards the reflector (10); and
- a first set (22; 204) of photovoltaic cells (24; 206), disposed in a third zone (26) of the envelope, having a first active face (28; 208) directed towards the reflector (10);
the first set (22; 204) of photovoltaic cells (24; 206) and the reflector (10) being configured so that the reflector (10) concentrates the solar radiation on the first active face (28; 208) of the first set (22; 204) of photovoltaic cells (24; 206), when the reflector (10) is in a solar alignment position;
the solar generator (8) further comprising a second set (32) of photovoltaic cells, disposed in a fourth zone of the envelope or in the third zone (26) of the envelope, and having a second active face directed towards the outside of the envelope (4); or
the solar generator (8) comprising a single first set (204), the solar cells of which are bifacial solar cells, and the first set (204) comprises a second active face (36) directed towards the outside of the envelope (4); and
the reflector (10), the first set (204) only of the bifacial photovoltaic cells (206) or the first and second sets (22, 32) of photovoltaic cells (24, 34) being configured so as to provide cooperative production of electric energy between the first active face (28; 208) and the second active face (36; 210) as long as the rolling solar misalignment of the reflector (10) is less than or equal to 10 degrees as an absolute value;
the balloon being **characterised in that**:
the second zone (16) of the envelope, transparent to solar radiation, partially or completely surrounds the third location zone (26) of the first set of photovoltaic cells intended to receive the solar radiation from the reflector; and
the surface of the second zone (16) is adjusted to provide sufficient illumination of the photovoltaic cells of the first set and to avoid excessive heating of the solar cells and/or of the envelope (4) and/or of the carrier gas (6) that the envelope (4) contains.

2. The balloon equipped with a solar generator with concentration according to claim 1, wherein the reflector (10), the first set (204) only of bifacial photovoltaic cells (206) or the first and second sets (22, 32) of photovoltaic cells (24, 34) are configured so as to maintain the illumination of the second active face (36; 210) as long as the rolling solar misalignment of the second active face (36; 210) is less than or equal to 80 degrees.

3. The balloon equipped with a solar generator with concentration according to any one of claims 1 to 2, wherein
the first and second sets of photovoltaic cells (22, 32) are separate and are respectively disposed in third and fourth different zones.

4. The balloon equipped with a solar generator with concentration according to any one of claims 1 to 2, wherein
the first and second sets of photovoltaic cells (22, 32) are separate and each comprise monofacial photovoltaic cells; and
the first and second sets are disposed on and outside the envelope in the same zone (26);
the first and second sets (22, 32) are mutually stacked, the second set (32) being disposed furthest outside the envelope (4) and the active faces of the photovoltaic cells of the first and second sets (22, 32) being oriented in opposite directions.

5. The balloon of a solar generator with concentration according to any one of claims 1 to 4, wherein the first set (22) and the second set (32) are mechanically separate from the envelope in terms of deformations of the envelope and/or are thermally separate from the envelope and from the carrier gas that the envelope contains.

6. The balloon equipped with a solar generator with concentration according to any one of claims 1 to 2, wherein
the first set (204) of photovoltaic cells is a set of bifacial photovoltaic cells (206) located above the third zone (26) of the envelope (4),
each bifacial cell (206) comprising a first face associated with a first electric polarisation and a second face associated with a second electric polarisation.

7. The balloon equipped with a solar generator with concentration according to claim 6, wherein the technology for manufacturing the bifacial cells (26) is technology that falls within the group formed by PERT (Passivated Emitter Rear Totally Diffused) silicon technology, HTJ (Heterojunction) heterojunction silicon technology and IBC (Interdigitated Back Contact) silicon technology.

8. The balloon equipped with a solar generator with concentration according to claim 7, wherein the manufacturing and connection technology for the bifacial cells (26) is technology for manufacturing heterojunction bifacial photovoltaic cells combined with SmartWire or SWCT connection technology.

9. The balloon equipped with a solar generator with concentration according to any one of claims 7 to 8, wherein the bifacial cells (206) are heterojunction bifacial photovoltaic cells
mutually arranged so as to produce one or more chains of solar cells electrically connected in series and to allow mutual planar interconnection of the cells on the same face without having to use interconnections passing through the thickness of the assembly (204) from one of its faces (208, 210) to the other.

10. The balloon equipped with a solar generator with concentration according to any one of claims 6 to 9, wherein the set (502) of photovoltaic cells comprises a plurality (504) of electronic protection switches (506, 508, 510) each having at least one junction forming a diode for protecting one or more photovoltaic cells for protecting the one or more cells against an increase in temperature following illumination uniformity defects in the second active faces by the reflector.

11. The balloon equipped with a solar generator with concentration according to any one of claims 6 to 10, wherein
the set (204) of bifacial photovoltaic cells (206) is thermally separated from the envelope (4) and the carrier gas (6) that the envelope (4) contains through a support and separation structure (40) for the set of cells of the envelope,
the support and separation structure (40) being fixed on the envelope in the third zone (26) and the set (204) of bifacial solar cells (26) being fixed on the support and separation structure (40),
and the space (48) delimited by the envelope (4), the structure (40) and the set (214) of cells forming an air circulation channel for cooling the bifacial solar cells (206) through natural or forced convection.

12. The balloon equipped with a solar generator with concentration according to claim 11, comprising one or more fans (52, 54, 56, 58) for circulating air through the channel and cooling the set (204) of photovoltaic cells (206).

13. The balloon equipped with a solar generator with concentration according to any one of claims 11 to 12, wherein the support and separation structure (40) is deformable in order to absorb the thermomechanical deformations of the envelope and/or to maintain a sufficient gap between the envelope and the set of cells to allow the cells to be cooled.
